# EUROPEAN PATENT SPECIFICATION

(11) **EP 0 527 035 B1**
(45) Date of publication and mention of the grant of the patent: **10.05.1995**
(21) Application number: 92307121.1
(22) Date of filing: 04.08.1992
(51) Int. Cl.: C01B 31/02, C30B 23/00, C30B 23/02

(54) **Process for the preparation of fullerene**
Verfahren zur Herstellung von Fulleren
Procédé de préparation de fullerène

(30) Priority: 07.08.1991 JP 198055/91; 30.04.1992 JP 111826/92
(43) Date of publication of application: 10.02.1993
(73) Proprietor: Mitsubishi Chemical Corporation, Chiyoda-ku Tokyo (JP)
(72) Inventor: Yoshida, Toyonobu, Tokyo (JP); Eguchi, Keisuke, Tokyo (JP); Yoshie, Kenichi, Yokohama-shi, Kanagawa-ken (JP)
(74) Representative: Woods, Geoffrey Corlett

(56) References cited:
- WO-A-92/04279
- CHEMICAL ABSTRACTS, vol. 104, no. 14, April 1986, Columbus, Ohio, US; abstract no. 112196r, 'Manufacture of carbon microballoons in plasma irradiated inert gases' page 140 .
- NATURE vol. 347, 27 September 1990, LONDON GB, pp. 336-337 , XP147104 MACKAY "carbon crystals wrapped up" and pp. 354-357

## Description

The present invention relates to a process for preparing fullerenes such as a C₆₀ or C₇₀ fullerene. These compounds can be used as high lubricants, high-hardness materials and catalyst carriers.

C₆₀ fullerene was discovered in 1985. This substance consists of 60 carbon atoms. In the ¹³C NMR spectrum, the only peak appears at δ = 142.7 ppm, which indicates that the 60 carbon atoms are equivalent (symmetrical) to each other. It is known that this substance has a shell-like structure of a truncated icosahedron consisting of 12 pentagons and 26 hexagons, which is generally referred to as a "soccer-ball" arrangement.
The hardness of this substance theoretically exceeds that of diamond, and it is also known that this substance has superconductivity when doped with a metallic element. Thus, utilization of this substance in various ways, such as application to the preparation of high lubricants, high-hardness materials and catalyst carriers is expected.

Isolation of the C₆₀ substance was reported in Nature, Vol. 347, page 354 (Sep. 27 1990 publication). According to the report, by electrifying and heating a graphite rod, or subjecting a pair of graphite rods to arc discharge in a He gas atmosphere of around 13300Pa (100 Torr), the C₆₀ substance is produced in the soot formed from the generated vapours. The soot is recovered and extracted with, for example, benzene and the C₆₀ substance is crystallized from the extract solution.

The C₇₀ substance is produced along with the C₆₀ substance in the soot. The C₆₀ and C₇₀ substances can be chromatographically separated with a solvent such as hexane by using a column of, for example, C₁₈ silica gel or alumina for reversed phase-chromatography.

Allotropes such as a C₂₄ substance, C₂₈ substance, C₃₂ substance, C₅₀ substance, C₈₄ substance, C₁₂₀ substance, C₂₄₀ substance and C₅₄₀ substance were found later; these allotropes are generically referred to as "fullerenes".

However, the method of producing the fullerenes by electrifying and heating a graphite rod, or conducting an arc discharge between a pair of graphite rods, has the problems set forth below and is unsuited for industrial production of fullerenes:
(1) it has very bad productivity because of the batch operation;
(2) it is impossible to make a uniform compositional adjustment of the products, since the vapours generated have varied composition and amounts due to change of the electrifying amount to the graphite rod; and
(3) the reaction system is complicated since the operation needs to be conducted under reduced pressure.

Thus there is a strong desire for a method which enables industrial production of the fullerenes, such as the C₆₀ substance and the C₇₀ substance, having a uniform composition.

The present invention provides a process for preparing fullerenes which comprises introducing a carbonaceous material, in the form discrete particles in the suspended state containing less than 0.05 wt% of particles exceeding 100 »m in particle size, along with a gas into hot plasma to heat and evaporate the carbon.

Fullerenes such as C₆₀ and C₇₀ fullerenes can be produced continuously according to the present invention with uniform composition and in a high yield.

The carbonaceous material is any material which is mainly composed of carbon. In certain cases such a material may contain elements other than carbon, such as hydrogen or oxygen, but a material with a high carbon content is preferably used. Typical examples of such material are carbon black, graphite powder, carbon fiber, coal powder, active carbon powder, charcoal powder and coke powder. A carbonaceous material of a low H/C or O/C molar ratio is preferred. When using a material in which the H/C or O/C molar ratio is less than 10⁻², it is possible to obtain the fullerenes in an even higher yield. Graphitized carbon black, graphite powder and graphitized carbon fiber can be exemplified as such a material.

As means for introducing the carbonaceous material into hot plasma, a method in which the carbonaceous material is dispersed in a gas stream and then introduced into hot plasma is preferred.

The form of the carbonaceous material, either powdery or fibrous, is not specifically limited so long as it can be easily evaporated after being heated in hot plasma. In the present invention, however, it is essential that the material be introduced into hot plasma in a suspended state and having a particle size of not more than 100 »m (i.e the content of the particles with a particle size of more than 100 »m is less than 0.05 wt%, preferably 0.01 to 20 »m, as measured according to the measuring method of dust particle-size distribution in an exhaust gas of JIS K 0302-1989.

It is preferable that the carbonaceous material contains not less than 60 wt.% of particles having a particle size of less than 20 »m, preferably 0.01 to 10 »m.

In ordinary powder, the particles stay in an aggregated state, so to suspend the fine particles mentioned above it is recommended to use a jet crusher or a disperser having high-speed rotor blades, if necessary in combination with a classifier such as a cyclone.

By using a carbonaceous material constituted entirely by ¹³C, a C₆₀ substance and/or a C₇₀ substance composed of ¹³C alone can be produced.

Any available source can be used for generating hot plasma in the present invention, so long as the source is capable of generating hot plasma of a sufficiently high temperature due to the evaporation of carbon and also having sufficient heat conductivity and retention time. Typical examples of such a source are a DC jet, a high-frequency inductive coupled-plasma (ICP), a hybrid-type combining a DC jet and ICP, and a hybrid-type combining 2 or 3 sets of ICP arranged in series.

When these plasma generating sources are used, it is possible to generate a hot plasma at 4,000-20,000°C with a sufficiently high heat conductivity (such as 0.1 to 100 mW· cm⁻¹K⁻¹) and a sufficiently long retention-time (such as 0.001 to 1.0 s). Such hot plasma is capable of easily evaporating carbon having a sublimation point of around 3,550°C.

The hot plasma used in the present invention thus has high heat conductivity and long retention time. It is also advantageous in that the hot plasma in the present invention is capable of elevating the evaporating efficiency of the carbon source and enhancing the precipitating efficiency of the C₆₀ substance and/or the C₇₀ substance. For ensuring these advantages, a system pressure of not less than 10 Torr (1.3 kPa), more preferably not less than 50 Torr (6.7 kPa), most preferably not less than 400 Torr (53 kPa), is preferred. However, too high a system pressure has a tendency to obstruct the generation of plasma and, in view of this, a system pressure of not higher than 2 atm (202 kPa), more preferably not higher than 1.5 atm (151 kPa), is preferred. Thus, in the present invention, the system pressure is generally selected from 10 Torr (1.3 kPa) to 2 atm (202 Kpa).

Among the hot plasma generating sources mentioned above, the high-frequency inductive coupled-type plasma (ICP) or a hybrid-type composed of ICP and a DC jet on a small-scale ICP is preferred because of the longer retention time.

The lower limit of the rate of which the carbonaceous material may be introduced is the amount which enables precipitation and recovery of a required amount of carbon. The upper limit is the rate which makes it possible to provide a sufficient calorific value due to the evaporation of carbon without extinguishing the plasma. Usually, the rate at which the carbonaceous material introduced in the present invention is 0.01 g/min or more. The upper limit depends on the input power for forming the hot plasma flow-zone and the plasma generating system, but in the case of ICP, for instance, the rate is not more than 10 g/min when the input power is 20 kw and not more than 100 g/min when the input power is 50 kw.

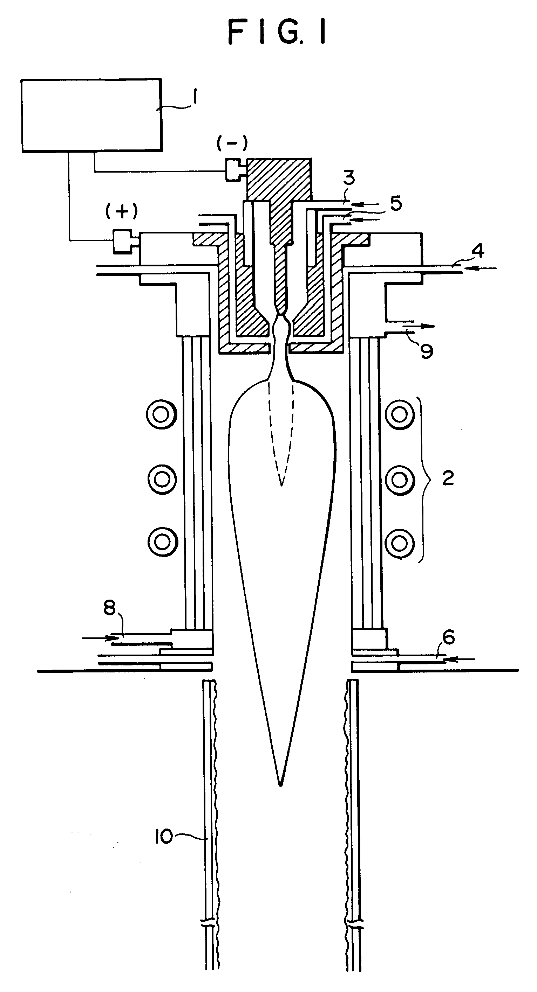

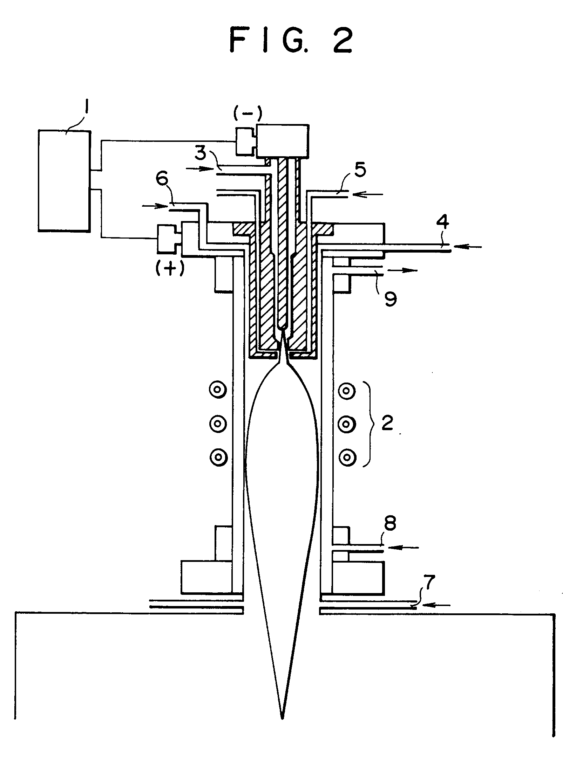

The plasma reaction systems used in the present invention are shown in Figs. 1 and 2.

In the present invention, the carbon heated and evaporated in hot plasma is reprecipitated as the gas is cooled spontaneously at the tail flame portion of the plasma. In this case, a cooling gas may be used for forcing a quick cooling.

An inert gas such as Ar or He can be used as the plasma gas. A carbonaceous material, preferably one having a high carbon content such as carbon black or graphite, is introduced while entraining the carbonaceous material in a stream of inert gas from the top of the reaction system. The flow rate of the inert gas is not critical in the present invention, but is preferably from 5 to 500 Nl/min. The product is deposited on a "pyrex" (trade mark) tube disposed downstream of the hot plasma, so the product is scraped away from the "pyrex" tube and recovered. The product is, also, recovered from a filter set further downstream than the "pyrex" tube.

The cooling rate can be controlled by the rate of feeding gas from a cooling gas inlet (6) shown in Fig. 1.

In the present invention, a cooling gas may introduced into the system to conduct quick cooling for precipitating the carbon heated and evaporated in hot plasma. The rate feeding the cooling gas may be the same as that commonly used for cooling in ordinary hot plasma. It is preferable to set the feeding rate of the cooling gas at 10% or higher, more preferably 50% or higher, than the flow rate of the plasma gas. An inert gas such as Ar, He, Ne or Xe or a gas which hardly reacts with carbon, such as N₂, is preferably used as the cooling gas. However, in order to enhance the cooling effect, there may be mixed in said gas hydrogen, oxygen, carbon monoxide, a halogen such as chlorine, carbon dioxide, a nitrogen oxide such as nitrogen dioxide, a sulfur compound such as sulfur dioxide, or various other gases in an amount which does not cause perfect gasification of carbon.

A water-cooled base plate may also be disposed immediately beneath the plasma zone to increase the cooling speed.

In the present invention, preparation of the C₆₀ substance and/or the C₇₀ to substance has been set as the primary objective, and it has been confirmed that these compounds can be produced in hot plasma. It is conceivable that a series of allotropes, that is, other fullerene such as a C₂₄ substance, C₂₈ substance, C₃₂ substance, C₅₀ substance, C₈₄ substance, C₁₂₀ substance, C₂₄₀ substance and C₅₄₀ substance, would also be produced by the same method.

In case that both the C₆₀ substance and the C₇₀ substance are produced concurrently with each other, their separation can be effected by any suitable conventional method, but usually they are chromatographically separated with a solvent such as hexane using a column of, for example C₁₆ silica gel or alumina in reversed phase chromatography.

According to the process of the present invention, fullerenes containing a metal or an element other than carbon, such as boron, nitrogen or phosphorus, may be produced by incorporating the metal or element in the starting material in the preparation process.

Specifically, it is possible to produce a compound identical with fullerenes in which a metal is contained, or a compound equal to fullerenes in which a part of its carbon atoms is replaced with a metal, both by introducing the carbon particles mixed with a proper amount of a metal or a metallic compound into the plasma gas.

The amount of the metals which are contained in the fullerenes or which replace the part of the fullerenes, is preferably 0.1 to 50 wt.%.

As the metal, a metal which has a small ionic radius, for example an alkali metal such as lithium, potassium, sodium, rubidium or cesium; an alkaline earth metal such as beryllium, magnesium, calcium, barium or strontium; a metal of Group IIIa of the Periodic Table such as scandium, yttrium or lanthanum; a lanthanoid metal such as neodymium, samarium, europium, terbium or ytterbium; or a transition metal of the 4th Period of the Periodic Table such as titanium, vanadium, chromium, manganese, iron, cobalt, nickel or zinc. As the metallic compound, an oxide, halide, carbonate, bicarbonate, oxalate, sulfide, sulfate or nitrates of the above-mentioned metals may, for example, be used.

It is also possible to produce fullerenes in which the carbon atoms thereof are replaced with boron, by introducing the carbon particles mixed with boron or a boron-containing compound such as boron carbide into the plasma.

It is further possible to produce fullerenes in which the carbon atoms thereof are replaced with nitrogen, by introducing the carbon particles into the plasma gas mixed with nitrogen. Fullerenes in which the carbon atoms thereof are replaced with nitrogen can be also produced by introducing a nitrogen-containing compound such as pyridine or quinoline in the form of a mist into the plasma gas.

Of course, combinations of the above steps are possible. For example, it is possible to synthesize metal-containing fullerenes in which a part of the skeletal carbon atoms is replaced with nitrogen and/or boron.

According to the process of this invention, the C₆₀ substance and/or C₇₀ substance can be obtained in a high yield (such as 1 % or higher). They can also be mass-produced continuously and efficiently. The C₆₀ substance can be effectively utilized as, for example, a lubricant, high-hardness material or cell material.

### EXAMPLES

The present invention is now further described in the following Examples.

In the experiments, hybrid plasma reactors adapted with a DC arc unit and a high-frequency arc unit in combination as shown in Figs. 1 and 2 were used.

In the drawings, 1 denotes a DC arc unit, 2 denotes a high-frequency arc unit, 3, 4, 5, 6 and 7 denote gas inlets, 8 denotes a cooling water conduit, 9 denotes a cooling water discharge pipe, and 10 denotes a pyrex tube.

### Example 1

In the hybrid plasma reactor shown in Fig. 1, a power of 5 kw was applied to the DC arc unit (1) and 20 kw (4 MHz) to the high-frequency arc unit (2) as input power. The reactor was previously evacuated to 0.05 Torr (6.7 Pa) by a hydraulic vacuum pump. After confirming that air leak into the system was not more than 0.05 cc/min, plasma gas was introduced into the reactor. Ar was used as the plasma gas. The gas was introduced from a gas inlet at a feeding rate of 10 Nl/min for the DC arc and at a feeding rate of 30 Nl/min as a whirling flow for the high-frequency arc.

As a cooling gas, Ar gas was also introduced from a gas inlet (6) at a feeding rate of 50 Nl/min.

Graphitized carbon black #4000B (produced by Mitsubishi Kasei Corporation) was used as the starting carbonaceous material. It was supplied into a gravity classifier while entraining the graphitized carbon black in a 2 Nl/min Ar gas stream from an airtight feeder and, after getting rid of particles having a particle size of more than 100 »m, the resultant carbon black was introduced into the system from a fine powder inlet (5) above the plasma.

The particle feeding rate was 2 g/min, and the pressure in the system was 760 Torr (101 kPa). The carbon black was perfectly decomposed in the plasma and then cooled downstream by the Ar gas stream at 50 Nl/min, which caused reprecipitation of the carbon. The products which were deposited on a downstream pyrex tube and collected by a filter were recovered. The recovered product was extracted with benzene to obtain a reddish-purple extract solution. When this solution was subjected to mass spectrometry, peaks at 720 amu and 840 amu were detected. When this solution was passed through a column packed with alumina particles using a hexane/benzene (5%) carrier solution and the separated purple solution was subjected to ¹³C NMR, a peak peculiar to C₆₀ was detected. The brown solution that came out behind said purple solution showed a peak peculiar to C₇₀. The recovery of a C₆₀ substance was 1% by weight based on the introduced carbon black, and that of a C₇₀ substance was 0.2% based on the introduced carbon black.

### Example 2

In the hybrid plasma reactor shown in Fig. 2, a power of 5 kw was applied to the DC arc unit (1) and 17 kw (4 MHz) to the high-frequency arc unit (2) as input power. The reactor was previously evacuated to 0.05 Torr (6.7 Pa) by a hydraulic vacuum pump. After confirming that air leak into the system was not more than 0.03 cc/min, plasma gas was introduced into the reactor. For the DC arc, argon gas was introduced at a feeding rate of 4 Nl/min from a gas inlet (3). For the high-frequency arc, argon gas was also introduced as a whirling flow at a feeding rate of 26 Nl/min from a gas inlet (4). Furthermore, a mixture of 12 Nl/min argon gas and 14 Nl/min helium gas was introduced in the radial direction from a gas inlet (6). A filter was set downstream, and was connected to a vacuum pump via a flow control valve. The pressure in the system was kept at 600 Torr (80 kPa) by adjusting the opening of the valve. Graphitized carbon black was used as the starting material as in Example 1. It was entrained in a 10 Nl/min stream of Ar gas, which was ejected from a 2 mmφ fine tube and hit against a downstream metal plate to cause dispersion. After getting rid of particles having a particle size of more than 100 »m by a gravity classifier, the resultant carbon black was introduced into the system at a feeding rate of 0.5 g/min from an inlet (5).

Determination of the particle size of the suspended particles in the gas according to JIS K-0302-1989 disclosed that particles with sizes of less than 10 »m accounted for 75 wt.% based on the whole particles.

The products which deposited on the wall of a downstream chamber and collected by a filter set further downstream were recovered. The recovered product was assayed in the same way as in Example 1. The C₆₀ substance and C₇₀ substance could be recovered at 5% and 2% by weight, respectively, based on the introduced carbon black.

### Example 3

An experiment similar to Example 2 was carried out with the same gas flow rate, the same plasma power and the same material introducing method as in Example 2 except for adjusting the pressure in the system to 260 Torr (35 kPa).

Recovery and assay of the product were also made in the same way as Example 2. The C₆₀ substance and C₇₀ substance could be recovered at 2.5% and 1% by weight, respectively, based on the introduced carbon black.

### Example 4

An experiment similar to Example 2 was carried out except that non-graphitized carbon black #40 (produced by Mitsubishi Kasei Corporation) was used as the starting material. The particle size of the suspended particles immediately before introduction of the material was the same as in Example 2. The C₆₀ substance and C₇₀ substance could be recovered at 2% and 0.5% by weight, respectively, based on the introduced carbon black.

### Example 5

An experiment similar to Example 2 was carried out using as starting material the ground and classified powder of calcined needle coke (produced by Mitsubishi Kasei Corporation). The starting particulate material in a suspended state immediately before introduction into the hot plasma reactor was such that 96 wt.% of the particles had a particle size of not more than 10 »m. There were no particles having a particle size of more than 100 »m.

In this experiment, the C₆₀ substance and C₇₀ substance could be recovered at 2% and 0.5% by weight, respectively, based on the starting powder.

### Example 6

An experiment similar to Example 2 was carried out using as starting material carbon black #4000B (produced by Mitsubishi Kasei Corporation) which had been mixed with 20 wt.% of yttrium oxide. As a result, about 2 wt.% of toluene extract was obtained from the recovered solid product. It was confirmed by ESR that this extract contained yttrium. Mass spectrometry of the extract detected YC₈₂, Y₂C₈₂ and Y₂C₈₄ peaks.

### Example 7

The same experiment as Example 2 was carried out except that carbon black #4000B (produced by Mitsubishi Kasei Corporation) which had been mixed with 2 wt.% of hexagonal boron nitride was used as starting material. As a result, about 5 wt.% of toluene extract was obtained from the recovered solid. Elemental analysis of the extract confirmed that this extract contained boron. Mass spectrometry of the extract detected C₅₉B, C₅₈B₂, C₅₇B₃ and C₅₆B₄ peaks.

### Example 8

The same experiment as Example 2 was carried out except that carbon black #4000B (produced by Mitsubishi Kasei Corporation) was used as starting material, that a mixture of 0.1 Nl/min of nitrogen and 25 Nl/min of argon for the plasma was introduced into the system from gas inlet (4), and that 23 Nl/min of argon was introduced in the radial direction from gas inlet (6). As a result, about 5 wt.% of toluene extract was obtained from the recovered solid. It was confirmed by elemental analysis that the extract contained nitrogen, and mass spectrometry of the extract detected C₅₉N, C₅₈N₂, C₅₇N3 and C₅₆N₄ peaks.

### Example 9

The experiment of Example 2 was carried out except for using as starting material carbon black #4000B (produced by Mitsubishi Kasei Corporation) which had been mixed with 5 wt.% of potassium iodide. As a result, about 5 wt.% of toluene extract was obtained from the recovered solid product. It was confirmed by ESR that the extract contained potassium. Mass spectrometry of the extract detected KC₆₀, KC₇₀ and KC₈₂ peaks.

### Example 10

The same experiment as Example 2 was carried out except that carbon black #4000B (produced by Mitsubishi Kasei Corporation) which had been mixed with 5 wt.% of calcium carbonate was used as starting material. As a result, about 5 wt.% of toluene extract was obtained from the recovered solid product. It was confirmed by ESR that the extract contained calcium. Mass spectrometry of the extract detected CaC₆₀, CaC₇₀ and CaC₈₂ peaks.

### Example 11

The experiment of Example 2 was carried out except for using as starting material carbon black #4000B (produced by Mitsubishi Kasei Corporation) which had been mixed with 5 wt.% of iron powder. As a result, about 5 wt.% of toluene extract was obtained from the recovered solid product. It was confirmed by ESR that the extract contained iron. Mass spectrometry of the extract detected FeC₆₀, FeC₇₀ and FeC₈₂ peaks.

### Comparative Example 1

An experiment similar to Example 2 was carried out except for using as starting material pulverized carbon black which had not been subjected to classification and which contained 40 wt.% of particles having a particle size of 100-1,000 »m. As a result, the C₆₀ substance and C₇₀ substance could be recovered at only 0.3% and 0.1% by weight, respectively, based on the introduced carbon black.

## Claims

1. A process for preparing fullerenes which comprises introducing a carbonaceous material, in the form of discrete particles in the suspended state containing less than 0.05 wt% of particles exceeding 100 »m in particle size, along with a gas into hot plasma to heat and evaporate the carbon.

2. A process according to claim 1 wherein the carbon heated and evaporated in hot plasma is cooled by a cooling gas.

3. A process according to claim 1 to 2 wherein the carbonaceous material contains not less than 60% by weight of particles having a particle size of less than 20 »m.

4. A process according to any one of the preceding claims wherein the hot plasma generating source is a DC jet, a high-frequency inductive coupled-plasma (ICP), a hybrid-type combining a DC jet and ICP, or a hybrid-type combining 2 or 3 sets of ICP arranged in series.

5. A process according to any one of the preceding claims wherein the carbonaceous material is introduced at a rate of not less than 0.01 g/min.

6. A process according to any one of the preceding claims wherein the gas introduced with the carbonaceous material is Ar or He.

7. A process according to any one of the preceding claims wherein the carbonaceous material is carbon black, graphite powder, carbon fibre, coal powder, active carbon powder, charcoal powder or coke powder.

8. A process according to any one of the preceding claims wherein the fullerene is a C₆₀ or C₇₀ fullerene.

9. A process according to any one of claims 1 to 7 wherein a metal or metallic compound, boron or a boron containing compound, nitrogen or a nitrogen containing compound or phosphorus or a phosphorus containing compound is also introduced into the hot plasma.

10. A process according to any one of the preceding claims which further comprises separating the desired fullerene.

## Patentansprüche

1. Verfahren zur Herstellung von Fullerenen, das das Zuführen eines kohlenstoffhaltigen Materials in der Form diskreter Teilchen im suspendierten Zustand, die weniger als 0,05 Gew.% an Teilchen mit einer 100 »m übersteigenden Teilchengrösse enthalten, zusammen mit einem Gas in heisses Plasma zum Erhitzen und Verdampfen des Kohlenstoffs beinhaltet.

2. Verfahren gemäss Anspruch 1, in dem man den Kohlenstoff, der im heissen Plasma erhitzt und verdampft wird, durch ein Kühlgas abkühlt.

3. Verfahren gemäss Ansprüchen 1 und 2, in dem das kohlenstoffhaltige Material nicht weniger als 60 Gew.% an Teilchen mit einer Teilchengrösse von weniger als 20 »m enthält.

4. Verfahren gemäss einem der vorangehenden Ansprüche, in dem die plasmaerzeugende Quelle ein DC (Gleichstrom)-Jet, ein Hochfrequenz-induktiv gekoppeltes Plasma (ICP), eine hybridartige Verbindung eines DC-Jets und eines ICPs oder eine hybridartige verbindung von zwei oder drei in Serie geschalteten ICP-Sets ist.

5. Verfahren gemäss einem der vorangehenden Ansprüche, in dem man das kohlenstoffhaltige Material mit einer Geschwindigkeit von nicht weniger als 0,01 g/min zuführt.

6. Verfahren gemäss einem der vorangehenden Ansprüche, in dem das Gas, das man mit dem kohlenstoffhaltigen Material zuführt, Ar oder He ist.

7. Verfahren gemäss einem der vorangehenden Ansprüche, in dem das kohlenstoffhaltige Material Russ, Graphitpulver, Kohlenstoffaser, Kohlepulver, Aktivkohlepulver, Holzkohlepulver oder Kokspulver ist.

8. Verfahren gemäss einem der vorangehenden Ansprüche, in dem das Fulleren ein C₆₀- oder C₇₀-Fulleren ist.

9. Verfahren gemäss einem der Ansprüche 1 bis 7, in dem man auch ein Metall oder eine metallische Verbindung, Bor oder eine Bor enthaltende verbindung, Stickstoff oder eine Stickstoff enthaltende Verbindung, oder Phosphor oder eine Phosphor enthaltende Verbindung dem heissen Plasma zuführt.

10. Verfahren gemäss einem der vorangehenden Ansprüche, das weiter die Abtrennung des erwünschten Fullerens beinhaltet.

## Revendications

1. Procédé de préparation de fullerènes, selon lequel on introduit une matière carbonée sous forme de particules discrètes à l'état de suspension, contenant moins de 0,05 % en poids de particules ayant une taille particulaire supérieure à 100 »m, en association avec un gaz, dans un plasma chaud, afin de chauffer et d'évaporer le carbone.

2. Procédé selon la revendication 1, dans lequel le carbone chauffé et évaporé dans le plasma chaud, est refroidi à l'aide d'un gaz réfrigérant.

3. Procédé selon la revendication 1 ou 2, dans lequel la matière carbonée ne contient pas moins de 60 % en poids de particules ayant une taille particulaire inférieure à 20 »m.

4. Procédé selon l'une quelconque des revendications précédentes, dans lequel la source génératrice de plasma chaud, est un jet généré par courant continu (DC), un plasma de couplage inductif à haute fréquence (ICP), un type hybride combinant un jet DC en plasma ICP ou un couple hybride combinant deux ou trois dispositifs à plasma ICP en série.

5. Procédé selon l'une quelconque des revendications précédentes, dans lequel la matière carbonée est introduite selon un débit inférieur à 0,01 g/mn.

6. Procédé selon l'une quelconque des revendications précédentes, dans lequel le gaz introduit avec la matière carbonée est Ar ou He.

7. Procédé selon l'une quelconque des revendications précédentes, selon lequel la matière carbonée est du noir de carbone, de la poudre de graphite, des fibres de carbone, de la poudre de charbon, de la poudre de carbone actif, de la poudre de charbon de bois ou de la poudre de coke.

8. Procédé selon l'une des revendications précédentes, dans lequel le fullerène est un fullerène en C₆₀ ou C₇₀.

9. Procédé selon l'une quelconque des revendications 1 à 7, dans lequel on introduit également dans le plasma chaud, un métal ou un composé de métal, du bore ou un composé du bore, de l'azote ou un composé de l'azote, ou du phosphore ou un composé du phosphore.

10. Procédé selon l'une quelconque des revendications précédentes, comprenant en outre la séparation du fullerène désiré.
